Europäisches Patentamt

European Patent Office

Office européen des brevets

(19)

(11) **EP 0 756 728 B1**

(12) **FASCICULE DE BREVET EUROPEEN**

(45) Date de publication et mention
de la délivrance du brevet:
**26.11.1997 Bulletin 1997/48**

(21) Numéro de dépôt: **95917319.6**

(22) Date de dépôt: **13.04.1995**

(51) Int Cl.⁶: **G06F 11/273**, H03M 11/02

(86) Numéro de dépôt international:
**PCT/EP95/01393**

(87) Numéro de publication internationale:
**WO 95/28675 (26.10.1995 Gazette 1995/46)**

(54) **CLAVIER DE COMMANDE, DISPOSITIF DE LECTURE ET DE DIAGNOSTIC DE DEFAILLANCES DE CE CLAVIER, ET LEUR UTILISATION A LA COMMANDE D'UN SIEGE DE VEHICULE AUTOMOBILE**

STEUERTASTATUR, LESE- UND DIAGNOSTIKVORRICHTUNG FÜR DIESE TASTATUR UND IHRE VERWENDUNG ZUR STEUERUNG EINES KRAFTWAGENSITZES

CONTROL KEYPAD, DEVICE FOR SENSING AND DIAGNOSING MALFUNCTIONS THEREOF, AND USE THEREOF FOR CONTROLLING A MOTOR VEHICLE SEAT

(84) Etats contractants désignés:
**DE GB**

(30) Priorité: **19.04.1994 FR 9404647**

(43) Date de publication de la demande:
**05.02.1997 Bulletin 1997/06**

(73) Titulaires:
- **SIEMENS AUTOMOTIVE S.A.**
  **31036 Toulouse Cédex (FR)**
- **BERTRAND FAURE FRANCE**
  **F-75008 Paris (FR)**

(72) Inventeurs:
- **LONCLE, André, Jean-Pierre**
  **F-31600 Toulouse (FR)**

- **LEROY, Yannick**
  **F-14100 Lisieux (FR)**

(74) Mandataire: **Fuchs, Franz-Josef, Dr.-Ing. et al**
  **Postfach 22 13 17**
  **80503 München (DE)**

(56) Documents cités:
**WO-A-86/03303**          **DE-B- 2 934 866**

- **IBM TECHNICAL DISCLOSURE BULLETIN.,
  vol.24, no.5, Octobre 1981, NEW YORK US pages
  2356 - 2357 ROMON R.F. ET AL. 'Keyboard
  diagnostics using dedicated matrix addresses'**

## Description

La présente invention est relative à un clavier de commande adapté à un dispositif de lecture et de diagnostic de défaillances de ce clavier. Plus particulièrement, la présente invention est aussi relative à l'utilisation d'un tel dispositif et d'un tel clavier pour commander un siège de véhicule automobile, notamment celui du conducteur du véhicule.

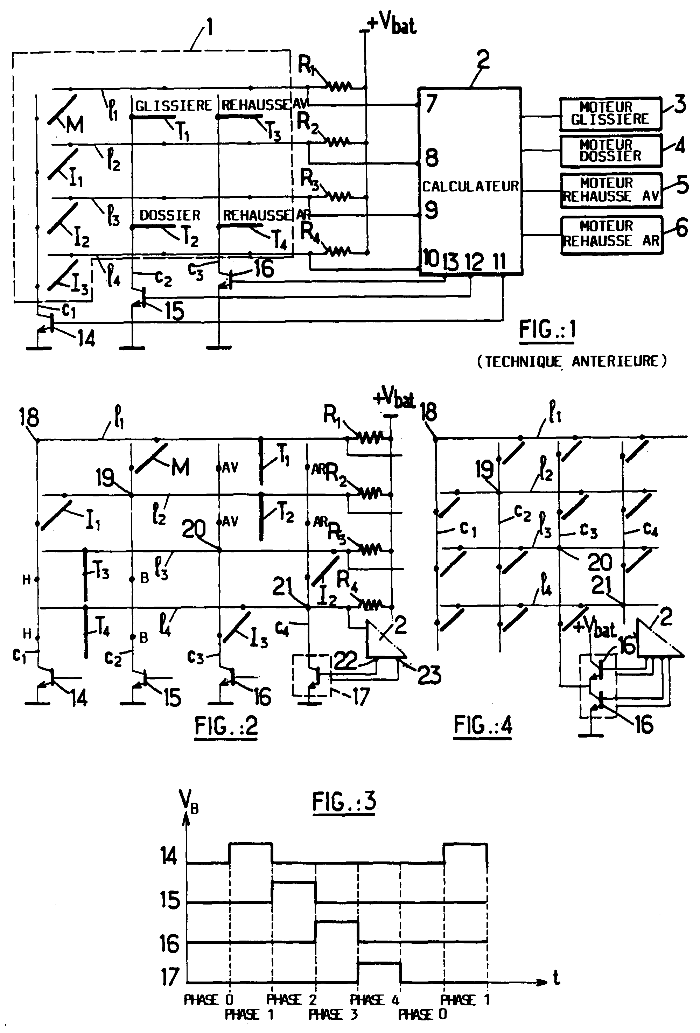

On équipe aujourd'hui couramment un tel siège de moyens permettant de modifier automatiquement sa position et sa configuration pour l'adapter à plusieurs conducteurs de corpulence et de taille différentes. La figure 1 du dessin annexé représente schématiquement de tels moyens, connus de la technique antérieure. Ceux-ci comprennent essentiellement un clavier de commande 1, un calculateur numérique 2 connecté au clavier pour "lire" l'état de celui-ci, et des moteurs 3,4,5 et 6 commandés par le calculateur 2 pour positionner et configurer le siège du véhicule en fonction d'informations chargées dans le calculateur à l'aide du clavier 1.

Le calculateur conserve en mémoire des données de position et de configuration de siège adaptées à plusieurs conducteurs différents. Lorsque l'un d'entre eux s'installe sur le siège, il appelle ces données en appuyant sur une touche de commande d'un interrupteur à contact-travail $I_1, I_2, I_3$ qui lui est affecté et qui commande l'appel des données mémorisées de position et de configuration du siège qui lui sont particulières, le calculateur élaborant à partir de ces données des commandes adaptées des moteurs 3 à 6 pour établir cette position et cette configuration particulières du siège.

La mémorisation préalable de ces données s'opère par une action du conducteur sur des touches de commande d'interrupteurs $T_1, T_2, T_3, T_4$, tels que des inverseurs à franchissement de point mort et rappel au centre, par exemple, commandant les moteurs électriques 3 à 6, réversibles, par l'intermédiaire du calculateur. Le moteur 3 agit sur la position du siège au long de glissières parallèles à l'axe longitudinal du véhicule, le moteur 4 agit sur l'inclinaison du dossier du siège, le moteur 5 agit sur la hauteur de l'avant de l'assise du siège, ou "rehausse AV", et le moteur 6 agit sur la hauteur de la partie arrière de ce siège, ou "rehausse AR".

Lorsqu'une position confortable est atteinte, le conducteur en commande la mémorisation par une action sur une touche de commande d'un interrupteur M d'activation de la mémoire du calculateur et sur une touche de commande de l'interrupteur $I_1$ à $I_3$ qui lui est affecté.

On comprend que le calculateur doit détecter l'état de tous les interrupteurs ou inverseurs du clavier. Pour ce faire, ceux-ci sont disposés suivant un agencement matriciel en lignes et en colonnes, les interrupteurs étant distribués entre plusieurs conducteurs de ligne $I_1, I_2, I_3, I_4$ et plusieurs conducteurs de colonne $c_1, c_2, c_3$, pour commander chacun sélectivement l'établissement d'un contact électrique entre le conducteur de ligne et le conducteur de colonne d'un couple particulier de tels conducteurs.

L'état de chaque interrupteur est détecté par une imposition séquentielle d'une première tension prédéterminée sur chacun des conducteurs de colonne et lecture des tensions résultantes sur les conducteurs de ligne, qui sont chacun polarisés à une deuxième tension prédéterminée, différente de la première. Dans un véhicule automobile, on peut commodément choisir la masse du véhicule et la tension $+V_{bat}$ disponible sur la borne positive de la batterie du véhicule, pour constituer ces première et deuxième tensions prédéterminées, respectivement. Les conducteurs de lignes $I_1$ à $I_4$ sont tirés à la tension $+V_{bat}$ à travers des résistances de rappel $R_1$ à $R_4$ respectivement. Des broches 7,8,9,10 du calculateur sont connectées aux points communs aux résistances $R_1$ à $R_4$ et aux conducteurs de ligne associés $I_1$ à $I_4$, respectivement, pour lire la tension établie sur ces conducteurs de ligne. D'autres broches 11,12,13 du calculateur commandent des transistors 14,15,16 montés sur les conducteurs de colonnes $c_1, c_2, c_3$ respectivement. En débloquant sélectivement ces transistors, le calculateur 2 met le conducteur de colonne correspondant à la masse.

Ainsi, si l'interrupteur M (mémoire) à contact-travail est fermé, alors que le calculateur a mis le conducteur de colonne $c_1$ à la masse, la tension sur le conducteur de ligne est tirée à la masse, ce dont le calculateur est informé par une relecture de la tension sur le conducteur $I_1$. Si au contraire l'interrupteur M est resté ouvert, la tension sur cette ligne reste à $+V_{bat}$ malgré la mise à la masse du conducteur $c_1$. Ainsi le calculateur peut-il "lire" l'état, ouvert ou fermé, de l'interrupteur M aussi bien que de tout autre interrupteur $I_1$ à $I_3$ par relecture de la tension sur un conducteur de ligne après mise à la masse sélective du conducteur de colonne associé. Il en est de même pour les inverseurs $T_1$ à $T_4$ dont les contacts mobiles ne peuvent simultanément s'appuyer sur les deux contacts fixes associés (AV,AR; H,B), disposés sur deux conducteurs de colonne différents. On remarquera incidemment que l'agencement matriciel des interrupteurs, et le procédé de détection de l'état de ces interrupteurs, décrits ci-dessus permettent au calculateur de connaître l'état de tous les interrupteurs avec sept liaisons électriques seulement alors qu'il en faudrait normalement douze ou treize. On limite ainsi avantageusement le câblage à installer entre le clavier et le calculateur.

Bien entendu, l'état des interrupteurs du clavier que le calculateur peut ainsi établir n'est fiable que dans la mesure où les connexions du clavier et du calculateur ne souffre d'aucune défaillance. A cet égard, six types de défaillances sont à redouter :

a) conducteur de colonne en circuit ouvert,
b) conducteur de colonne court-circuité à la masse,
c) conducteur de colonne court-circuité à $+V_{bat}$,
d) conducteur de ligne en circuit ouvert,
e) conducteur de ligne court-circuité à la masse,
f) conducteur de ligne court-circuité à $+V_{bat}$.

Toutes ces défaillances ne peuvent être détectées par le calculateur du dispositif représenté à la figure 1. Seule la défaillance c) peut être détectée simplement. En effet, un court-circuit à $+V_{bat}$ d'un conducteur de colonne, $c_1$ par exemple, provoque un court-circuit à cette même tension du collecteur du transistor 14, détecté par le calculateur lors de la commande du transistor 14. En effet, dans l'environnement automobile envisagé, ce transistor est classiquement auto-protégé, avec émission d'un diagnostic de défaut, comme décrit par exemple dans le brevet US-A-4 799 126 relatif à un dispositif d'alimentation électrique d'une charge, équipé d'un commutateur "intelligent".

Les défauts b) e) et f) ne sont détectables que si, au moment du diagnostic, une touche de commande d'interrupteur est enfoncée.

Les défauts a) et d) d'ouverture de circuit de conducteur de colonne et de ligne respectivement, sont les plus probables et totalement indétectables. En effet, le calculateur ne peut alors distinguer ces défauts d'une absence de fermeture d'interrupteur sur la ligne ou sur la colonne concernée.

La présente invention a donc pour but de réaliser un clavier de commande conçu pour permettre à un dispositif associé de lecture de ce clavier, de diagnostiquer toutes les défaillances susceptibles d'affecter la validité de la lecture.

La présente invention a aussi pour but de réaliser un tel clavier et un tel dispositif, plus particulièrement conçus pour assurer la commande automatique d'un siège de véhicule automobile, dans une position et une configuration mémorisées.

On atteint ces buts de l'invention, ainsi que d'autres qui apparaîtront à la lecture de la description qui va suivre, avec un clavier de commande constitué par un agencement matriciel d'interrupteurs commandés par des touches, ces interrupteurs étant distribués entre m conducteurs de ligne et n conducteurs de colonne pour commander chacun sélectivement l'établissement d'un contact électrique entre les conducteurs de ligne et de colonne, respectivement, d'un couple particulier de tels conducteurs, l'état de chaque interrupteur étant détecté par imposition séquentielle d'une première tension prédéterminée sur chacun des conducteurs de colonne et lecture des tensions résultantes sur les conducteurs de ligne, polarisés à une deuxième tension prédéterminée différente de la première. Suivant l'invention, chaque conducteur de ligne ou de colonne est en court-circuit permanent avec au moins un conducteur de colonne ou de ligne, respectivement.

Comme on le verra plus haut, cette disposition permet notamment de diagnostiquer simplement les ouvertures des circuits des conducteurs de ligne et de colonne, défaillances du clavier qui sont les plus probables.

Pour ce faire, l'invention fournit un dispositif de lecture et de diagnostic de défaillances du clavier comprenant des moyens de commande séquentielle des conducteurs de colonne à la première tension prédéterminée et des moyens de lecture des tensions résultantes sur les conducteurs de ligne, polarisés à travers des résistances à la deuxième tension prédéterminée. Suivant l'invention, ce dispositif comprend des moyens sensibles à la lecture d'une tension égale à la deuxième tension prédéterminée sur l'un quelconque des conducteurs de ligne lors de la commande à la première tension du conducteur de colonne en court-circuit permanent avec ce conducteur de ligne, pour diagnostiquer une ouverture du circuit de ce conducteur de colonne.

D'autres caractéristiques et avantages du clavier et du dispositif suivant l'invention apparaîtront à la lecture de la description qui va suivre et à l'examen du dessin annexé dans lequel :

- la figure 1 est une vue schématique du clavier et du dispositif de lecture de ce clavier et de commande d'un siège de véhicule automobile décrit en préambule de la présente description,
- la figure 2 est une représentation schématique d'un clavier et d'un dispositif de lecture et de diagnostic de défaillances de ce clavier, suivant l'invention,
- la figure 3 est un chronogramme d'une commande séquentielle des conducteurs de colonne du clavier de la figure 2, utilisable par le dispositif suivant l'invention et,
- la figure 4 représente schématiquement une variante du clavier et du dispositif suivant l'invention.

Aux figures 2 et 4, des références identiques ou similaires à des références utilisées à la figure 1 repèrent des éléments ou organes identiques ou similaires.

A la figure 2, le clavier représenté comprend ainsi les mêmes interrupteurs $I_1, I_2, I_3$, M et $T_1$ à $T_4$ que celui de la figure 1, disposés suivant un agencement matriciel de quatre lignes et de quatre colonnes. C'est ainsi que le clavier comprend un quatrième conducteur de colonne $c_4$, absent du clavier de la technique antérieure représentée à la figure 1. Comme on le verra plus loin, la présence de ce quatrième conducteur de colonne est nécessaire pour que soit assuré un diagnostic complet de toutes les défaillances susceptibles d'affecter le clavier suivant l'invention. Elle ne diminue pas sensiblement les avantages tirés, en matière de câblage, de l'agencement matriciel de ce clavier.

Suivant une caractéristique essentielle du clavier selon l'invention, chaque conducteur de colonne est en court-circuit permanent avec un conducteur de ligne. C'est ainsi que, dans le mode de réalisation de l'invention décrit à titre d'exemple où $m = n = 4$, n conducteurs de colonne $c_1, c_2, c_3, c_4$ sont court-circuités à m conducteurs de ligne $I_1, I_2, I_3, I_4$ respectivement, en 18,19,20,21 respectivement.

On remarquera par ailleurs, que, suivant une disposition particulière du clavier selon l'invention, les interrupteurs inverseurs $T_1, T_4$ comprennent chacun un contact mobile connecté à un connecteur de ligne particulier, entre deux conducteurs de colonne adjacents connectés chacun électriquement à l'un de deux plots de contact fixe. C'est ainsi que le contact mobile de l'interrupteur $T_1$, par exemple, est connecté au conducteur de ligne $l_1$ et que ses plots de contact fixe AV,AR sont connectés aux conducteurs de colonne $c_3$ et $c_4$ respectivement. Chaque conducteur de ligne est ainsi connecté à un seul contact mobile. On verra plus loin l'intérêt de cette disposition dans la détection d'un court-circuit à la masse d'un conducteur de ligne.

Comme dans le clavier de la figure 1, les conducteurs de colonne $c_1,c_2,c_3,c_4$ du clavier de la figure 2 sont connectés à la masse à travers des transistors 14,15,16,17 commandés par le calculateur 2. On a représenté en plus de détail le seul transistor 17 de commande du conducteur de colonne $c_4$ pour la clarté de la figure. Celui-ci est classiquement commandé par le calculateur 2, par l'intermédiaire d'une broche 22 de ce calculateur. Classiquement encore, le transistor est muni de moyens de détection de surcourant (non représentés) formant un signal représentatif de cette situation, ce signal étant reçu par une broche 23 du calculateur. A la réception d'un tel signal, le calculateur commande le blocage du transistor pour assurer la protection de celui-ci.

Par ailleurs, les conducteurs de ligne $l_1$ à $l_4$ sont connectés à des broches 7,8,9,10 du calculateur respectivement et, à travers des résistances $R_1$ à $R_4$ respectivement, à la tension $+V_{bat}$, comme les conducteurs de ligne du clavier de la figure 1. Les broches 7 à 10 sont elles-mêmes classiquement équipées chacune d'un dispositif d'autoprotection en courant qui se déclenche lorsqu'un courant d'une intensité supérieure à une intensité prédéterminée passe dans le conducteur de ligne auquel elle est raccordée.

La lecture du clavier suivant l'invention s'opère classiquement, comme celle du clavier de la figure 1, par commande séquentielle des conducteurs de colonne à la masse et relecture des tensions sur les conducteurs de ligne, le calculateur identifiant l'état de chaque interrupteur pour en tirer des commandes appropriées des moteurs 3 à 6, comme on l'a vu plus haut. La validation des informations tirées du clavier ainsi "scruté" exige que l'on soit assuré du bon état de fonctionnement du clavier, soit essentiellement de l'absence de défaillances dans les connexions électriques de celui-ci.

Pour ce faire, le dispositif de lecture et de diagnostic suivant l'invention comprend des moyens logiciels prévus dans le calculateur 2, propres à commander périodiquement la "lecture" du clavier et le diagnostic de son état de fonctionnement, comme on le verra plus loin en liaison avec la figure 4. Ces moyens logiciels sont programmés pour être sensibles, en période de test, aux tensions lues sur les conducteurs de ligne lors des connexions séquentielles à la masse des conducteurs de colonne, et à d'éventuels déclenchements d'autoprotection des broches du calculateur, pour détecter l'apparition de l'une quelconque des défaillances électriques possibles du clavier suivant l'invention, comme on l'explique ci-dessous, défaillance par défaillance :

a) conducteur de colonne en circuit ouvert

A la commande d'un transistor 14 à 17 qui met le conducteur de colonne correspondant à la masse, les moyens logiciels sont sensibles à la lecture de la tension $+V_{bat}$ sur le conducteur de ligne en court-circuit permanent avec ce conducteur de colonne, pour diagnostiquer une ouverture du circuit du conducteur de colonne. En effet, cette ouverture empêche la mise à la masse de ce conducteur, qui reste alors à la tension $+V_{bat}$ du fait de son court-circuit permanent, suivant l'invention, avec un conducteur de ligne. C'est ainsi que, par exemple, les moyens logiciels diagnostiquent l'ouverture du circuit du conducteur de colonne $c_4$ quand, au déblocage du transistor 17, le calculateur lit la tension $+V_{bat}$ sur le conducteur de ligne $l_4$. Dans cette hypothèse, le calculateur ne tient pas compte de l'état de l'interrupteur $I_2$, lu de manière défectueuse du fait du circuit ouvert diagnostiqué.

b) court-circuit à la masse d'un conducteur de colonne

Si, en l'absence de toute commande de conducteur de colonne, on lit sur un conducteur de ligne le potentiel de la masse, cela est significatif de ce que le conducteur de colonne en court-circuit permanent avec ce conducteur de ligne est en court-circuit à la masse. Les informations d'état relatives aux interrupteurs placés sur le conducteur de colonne ne sont alors pas prises en compte.

c) conducteur de colonne court-circuité au potentiel d'alimentation $+V_{bat}$

Un tel court-circuit, du conducteur de colonne $c_4$ par exemple, porte le collecteur du transistor 17 à $+V_{bat}$ ce qui entraîne immédiatement une détection de surcourant dans ce collecteur, à la commande de ce conducteur de colonne. Un signal significatif de ce surcourant est envoyé à la broche 23 du calculateur qui commande alors le blocage du transistor pour protéger celui-ci. Dans cette hypothèse, les informations d'état des interrupteurs de la colonne $c_4$, tirées de la lecture du clavier par le dispositif suivant l'invention, ne sont pas prises en compte.

d) conducteur de ligne en circuit ouvert

Lorsque ce défaut affecte un conducteur de ligne, celui-ci n'est plus connecté au conducteur de colonne correspondant. Ainsi par exemple, s'il affecte le conducteur de ligne $l_1$, quand le conducteur de colonne $c_1$ est mis à la masse par la commande du transistor 14, le calculateur lit $+V_{bat}$ sur le conducteur de ligne $l_1$ alors que ce conducteur devrait être à la masse du fait de son court-circuit permanent en 18 au conducteur de colonne

$c_1$. Dans ces conditions le calculateur ne tient pas compte des états lus des interrupteurs M et $T_1$ placés sur le conducteur de ligne $l_1$.

e) *court-circuit d'un conducteur de ligne à la masse*

Lorsque le conducteur de ligne $l_2$, par exemple, est en court-circuit à la masse, le dispositif de lecture suivant l'invention devrait détecter normalement une fermeture simultanée des interrupteurs $l_1$ et $l_2$, lors des commandes successives des transistors 14 à 17. Or le contact mobile de l'interrupteur inverseur $T_2$ ne peut être à la fois fermé sur le conducteur de colonne $c_3$ et sur le conducteur $c_4$. On programme le calculateur 2 pour que celui-ci diagnostique un défaut de court-circuit à la masse du conducteur de ligne $c_2$, après lecture de la tension de masse sur ce conducteur lors des commandes successives des conducteurs de colonne $c_3$ et $c_4$.

Suivant l'invention, lorsque le clavier compte au moins autant d'interrupteurs-inverseurs $T_1$-$T_4$ qu'il y a de conducteurs de ligne, comme ce peut être le cas dans un clavier de commande de siège automobile, on dispose avantageusement un interrupteur-inverseur sur chaque conducteur de ligne pour pouvoir diagnostiquer un éventuel court-circuit à la masse de chacun de ces conducteurs, comme représenté, par exemple, sur la figure 2.

f) *court-circuit à $+V_{bat}$ d'un conducteur de colonne*

Si le conducteur de ligne $l_1$ est en court-circuit à $+V_{bat}$, lors de la fermeture du transistor 14, le surcourant passant dans $l_1$ provoque le déclenchement de l'auto-protection en courant de la broche 7 du calculateur. Le calculateur déduit de ce déclenchement l'existence de ce court-circuit et ne prend pas en compte les informations d'état concernant les interrupteurs M et $T_1$. Ce mécanisme de détection de court-circuit à $+V_{bat}$ s'applique évidemment aux autres conducteurs de ligne.

Il apparaît ainsi que le clavier et le dispositif de lecture et de diagnostic de ce clavier, suivant l'invention, permettent de diagnostiquer l'ensemble des défaillances électriques susceptibles d'affecter la validité de la lecture par le dispositif des états des interrupteurs du clavier. Le diagnostic ainsi établi présente plusieurs avantages. Il couvre l'ensemble des défauts, y compris les ouvertures des circuits des conducteurs de ligne et de colonne et il autorise la détection des défauts référencés b, e et f ci-dessus, sans exiger pour cela la fermeture simultanée d'un interrupteur concerné. Tous ces avantages sont obtenus au prix de l'incorporation d'un conducteur de colonne supplémentaire, dans le clavier de commande de siège d'automobile représenté à titre d'exemple, ce qui ne grève pas sensiblement les avantages que l'on tire du caractère matriciel de ce clavier.

Le chronogramme de la figure 3 illustre une procédure de lecture et de diagnostic de défaut du clavier suivant l'invention. On a représenté la succession dans le temps des commandes des transistors 14 à 17 associés aux conducteurs de colonne $c_1$ à $c_4$ respectivement. Au niveau "HAUT" de la tension de base $V_B$ d'un transistor, celui-ci est passant et il est bloqué au niveau "BAS". La commande séquentielle des transistors 14,15,16,17 lors des phases successives 1, 2, 3, 4 respectivement, après une phase 0 dans laquelle tous les transistors sont bloqués, permet la lecture des états des interrupteurs et le diagnostic de défaut.

En ce qui concerne les positions des interrupteurs-inverseurs $T_1$ (glissière) et $T_2$ (dossier) on a repéré AV et AR sur la figure 3 les contacts qui sont fermés pour avancer ou reculer, respectivement, le siège sur ces glissières par action sur l'interrupteur-inverseur $T_1$, ou pour basculer vers l'avant ou vers l'arrière respectivement, le dossier du siège (interrupteur-inverseur $T_2$). De même, on a identifié H et B les contacts des interrupteurs-inverseurs $T_3$ et $T_4$ que l'on ferme pour faire monter ou descendre l'avant (interrupteur $T_3$) ou l'arrière (interrupteur $T_4$) de l'assise du siège. Avec ces notations, la procédure de lecture du clavier et de diagnostic de défaut électrique suivant l'invention peut s'établir selon la séquence suivante :

- phase 0 : détection du défaut b,
- phase 1 : lecture $l_1$, lecture $T_3$ (position H), lecture $T_4$ (position H),
  détection des défauts a, c, d, f
- phase 2 : lecture M, $T_3$ (position B), $T_4$ (position B)
  détection des défauts a, c, d, f
- phase 3 : lecture $l_3$, $T_1$ (position AV), $T_2$ (position AV)
  détection des défauts a, c, d, f
- phase 4 : lecture $l_2$, $T_1$ (position AR), $T_2$ (position AR),
  détection des défauts a, c, d, f

Le calculateur connaît alors les positions de tous les interrupteurs, y compris celles des inverseurs $T_1$ à $T_4$. Les lectures obtenues des positions de ces inverseurs permettent le diagnostic de la présence d'un défaut du type e, comme on l'a vu plus haut en liaison avec la description de ce diagnostic.

Bien entendu l'invention n'est pas limitée au mode de réalisation décrit et représenté à la figure 2, qui n'a été donné qu'à titre d'exemple. C'est ainsi que l'invention s'étend au test d'un clavier de commande d'un nombre $i$ quelconque de mouvements et/ou d'un nombre j quelconque de positions à mémoriser. Le câblage le plus économique étant celui qui compte autant de conducteurs de ligne que de conducteurs de colonne (soit m = n), on choisit alors m = partie entière de $\sqrt{2i + j} + 1$, et on ajoute entre les conducteurs de ligne et de colonnes des court-circuits en nombre égal à max (m,n).

Des stratégies de lecture et de diagnostic autres que celle décrite en liaison avec les chronogrammes de la figure 3 pourraient être mises en oeuvre. Les informations de défaillance et d'état des interrupteurs acquises comme indiqué ci-dessus peuvent être soumises à des traitements tels que des filtrages par exemple, avant d'être prises en compte. Les tensions de masse et $+V_{bat}$ appliquées respectivement aux conducteurs de ligne et aux conducteurs de colonne n'ont été choisies que parce qu'elles sont immédiatement disponibles dans un véhicule automobile. Elles pourraient être remplacées par des tensions présentant d'autres niveaux.

L'invention s'étend encore à des claviers ayant d'autres objets que la commande d'un siège d'automobile et/ou ne comprenant pas d'inverseurs, comme c'est le cas de celui représenté à la figure 4. Le diagnostic du défaut e) (court-circuit d'un conducteur de ligne à la masse) exige alors une double commande des conducteurs de colonne, comme représenté à titre d'exemple sur le conducteur $c_3$ du clavier de la figure 4. Deux transistors 16,16' sont montés en série entre une connexion à la tension $+V_{bat}$ et une connexion à la masse, leur borne commune étant connectée au conducteur de colonne $c_3$. En débloquant sélectivement le transistor 16 ou le transistor 16' (l'autre restant bloqué), le calculateur commande la connexion du conducteur $c_3$ à la masse (comme dans le clavier de la figure 2) ou à $+V_{bat}$ respectivement. En connectant sélectivement $c_3$ à $+V_{bat}$, le calculateur peut diagnostiquer un court-circuit à la masse du conducteur de ligne $l_3$ en court-circuit permanent en 20 avec $c_3$. En effet, en présence d'un tel court-circuit à la masse de $l_3$, la commande à $+V_{bat}$ du conducteur $c_3$ déclenche l'auto-protection du transistor 16' contre le surcourant alors développé, déclenchement significatif de l'existence du défaut en question.

## Revendications

1. Clavier de commande constitué par un agencement matriciel d'interrupteurs commandés par des touches, ces interrupteurs étant distribués entre m conducteurs de ligne ($l_1$ à $l_m$) et $\underline{n}$ conducteurs de colonne ($c_1$ à $c_n$) pour commander chacun sélectivement l'établissement d'un contact électrique entre les conducteurs de ligne et de colonne, respectivement, d'un couple particulier de tels conducteurs, l'état de chaque interrupteur ($M, l_1$ à $l_3, T_1$ à $T_4$) étant détecté par imposition séquentielle d'une première tension prédéterminée sur chacun des conducteurs de colonne et lecture des tensions résultantes sur les conducteurs de ligne, polarisées à une deuxième tension prédéterminée différente de la première, ce clavier étant caractérisé en ce que chaque conducteur de ligne ($l_1$ à $l_m$) ou de colonne ($c_1$ à $c_n$) est en court-circuit permanent avec au moins un conducteur de colonne ou de ligne, respectivement.

2. Clavier conforme à la revendication 1, comprenant au moins un interrupteur ($T_1$ à $T_4$) à contact mobile pivotant entre deux plots de contact fixes (AV,AR;

H,B) caractérisé en ce que le contact mobile de l'interrupteur est connecté électriquement à un conducteur de ligne ($l_1$ à $l_m$) particulier, entre deux conducteurs de colonne adjacents connectés chacun électriquement à l'un des deux plots de contacts fixes.

3. Clavier conforme à la revendication 2, caractérisé en ce que chaque conducteur de ligne est connecté à au moins un interrupteur à contact mobile pivotant entre deux plots de contact fixes.

4. Clavier conforme à la revendication 1, comportant seulement des interrupteurs à deux plots de contacts fixes et un contact mobile entre une position d'ouverture et une position de fermeture sur ces plots, caractérisé en ce qu'il comprend des moyens (16,16') pour porter sélectivement chaque conducteur de colonne ($c_1$ à $c_n$) à l'une ou l'autre des première et deuxième tensions prédéterminées.

5. Dispositif de lecture et de diagnostic de défaillances du clavier conforme à l'une quelconque des revendications 1 à 4, comprenant des moyens de commande séquentielle des conducteurs de colonne ($c_1$ à $c_n$) à la première tension prédéterminée et des moyens de lecture des tensions résultantes sur les conducteurs de ligne ($l_1$ à $l_m$), polarisés à travers des résistances à la deuxième tension prédéterminée, caractérisé en ce qu'il comprend des moyens sensibles à la lecture d'une tension égale à la deuxième tension prédéterminée sur l'un quelconque des conducteurs de ligne ($l_1$ à $l_m$) lors de la commande à la première tension du conducteur de colonne en court-circuit permanent avec ce conducteur de ligne, pour diagnostiquer une ouverture du circuit de ce conducteur de colonne.

6. Dispositif conforme à la revendication 5, en combinaison avec le clavier conforme à la revendication 2, caractérisé en ce qu'il comprend des moyens sensibles à la lecture d'une tension égale à la première tension prédéterminée sur un conducteur de colonne lors des commandes successives à cette première tension des deux conducteurs de colonne connectés aux contacts fixes de l'interrupteur ($T_1$ à $T_4$) dont le contact mobile est connecté audit conducteur de ligne, pour diagnostiquer un court-circuit à la première tension dudit conducteur de ligne.

7. Dispositif conforme à l'une quelconque des revendications 5 et 6, caractérisé en ce qu'il comprend des moyens sensibles à la lecture de la première tension sur un conducteur de ligne, en l'absence de commande à cette première tension du conducteur de colonne en court-circuit avec ledit conducteur de ligne, pour diagnostiquer un court-circuit du conducteur de colonne à la première tension.

8. Dispositif conforme à l'une quelconque des revendications 5 à 7, caractérisé en ce qu'il comprend des moyens sensibles à la lecture de la deuxième tension sur un conducteur de ligne après la commande à la première tension du conducteur de colonne en court-circuit permanent avec ce conducteur de ligne, pour diagnostiquer une ouverture du circuit dudit conducteur de ligne.

9. Dispositif conforme à l'une quelconque des revendications 5 à 7, dans lequel les moyens de lecture des tensions des conducteurs de ligne font partie d'un calculateur (2) comprenant $\underline{m}$ broches autoprotégées en courant et connectées chacune à un desdits conducteurs de ligne, caractérisé en ce que ledit calculateur comprend des moyens sensibles au déclenchement de l'autoprotection de la broche connectée à un conducteur de ligne, après la commande à la deuxième tension du conducteur de colonne en court-circuit permanent avec ce conducteur de ligne, pour diagnostiquer un court-circuit de ce conducteur de ligne à la deuxième tension.

10. Dispositif conforme à l'une quelconque des revendications 5 à 9, dans lequel les moyens de commande en tension des conducteurs de colonne sont des transistors (14,15,16,17) commandés par un calculateur (2) sensible à la détection d'un surcourant dans l'un quelconque de ces transistors pour commander le blocage de celui-ci, caractérisé en ce que calculateur (2) comprend des moyens pour diagnostiquer un court-circuit d'un conducteur de colonne à la deuxième tension prédéterminée, en réponse à une détection d'un surcourant dans le transistor de commande de ce conducteur.

11. Dispositif conforme à la revendication 5, en combinaison avec le clavier conforme à la revendication 3, caractérisé en ce qu'il comprend en outre des moyens de commande séquentielle de chacun des conducteurs de colonne à la deuxième tension prédéterminée, à travers un transistor (16') muni de moyens de détection d'un surcourant, et des moyens sensibles à la détection d'un tel surcourant dans ce transistor à la commande d'un conducteur de colonne à la deuxième tension prédéterminée, pour diagnostiquer la présence d'un court-circuit à la première tension du conducteur de ligne en court-circuit permanent avec ce conducteur de colonne.

12. Utilisation d'un dispositif conforme à l'une quelconque des revendications 5 à 11, à la lecture et au diagnostic d'un clavier de commande d'un siège de véhicule automobile.

13. Utilisation conforme à la revendication 12, caractérisée en ce que les première et deuxième tensions prédéterminées sont constituées par la tension de masse et la tension ($+V_{bat}$) de la batterie du véhicule, respectivement.

**Patentansprüche**

1. Steuertastatur, die aus einer Matrixanordnung von durch Tasten gesteuerten Schaltern besteht, wobei die Schalter zwischen m Zeilenleitern ($l_1$-$l_m$) und n Spaltenleitern ($c_1$-$c_n$) verteilt sind, um jeweils wahlweise die Herstellung eines elektrischen Kontaktes zwischen den Zeilenleitern bzw. Spaltenleitern eines speziellen Paares dieser Leiter zu steuern, wobei der Zustand jedes Schalters (M, $l_1$-$l_3$, $T_1$-$T_4$) dadurch erfaßt wird, daß sequentiell eine erste vorgegebene Spannung an jeden der Spaltenleiter angelegt wird und die resultierenden Spannungen in den Zeilenleitern gelesen werden, welche mit einer von der ersten Spannung verschiedenen vorgegebenen zweiten Spannung vorgespannt sind, wobei die Tastatur dadurch gekennzeichnet ist, daß jeder Zeilenleiter ($l_1$-$l_m$) oder Spaltenleiter ($c_1$-$c_n$) mit mindestens einem Spaltenleiter bzw. Zeilenleiter permanent kurzgeschlossen ist.

2. Tastatur nach Anspruch 1, mit mindestens einem Schalter ($T_1$-$T_4$) mit beweglichem Kontakt, der zwischen zwei festen Kontaktstellen (AV, AR; H, B) schwenkbar ist, dadurch gekennzeichnet, daß der bewegliche Kontakt des Schalters elektrisch mit einem speziellen Zeilenleiter ($l_1$-$l_m$) zwischen zwei benachbarten Spaltenleitern verbunden ist, die jeweils elektrisch mit dem einen der beiden festen Kontaktstellen verbunden sind.

3. Tastatur nach Anspruch 2, dadurch gekennzeichnet, daß jeder Zeilenleiter mit mindestens einem Schalter mit beweglichem Kontakt verbunden ist, der zwischen zwei festen Kontaktstellen schwenkbar ist.

4. Tastatur nach Anspruch 1, die nur Schalter mit zwei festen Kontaktstellen und einem zwischen einer Öffnungsstellung und einer Schließstellung an diesen Kontaktstellen beweglichen Kontakt aufweist, dadurch gekennzeichnet, daß er Mittel (16, 16') aufweist, durch die wahlweise an jeden Spaltenleiter ($c_1$-$c_n$) die eine oder andere der beiden vorgegebenen Spannungen anlegbar ist.

5. Vorrichtung zum Erfassen und Diagnostizieren von Fehlern der Tastatur gemäß einem der Ansprüche 1 bis 4, mit Mitteln zum sequentiellen Ansteuern der Spaltenleiter ($c_1$-$c_n$), mit der ersten vorgegebenen Spannung und Mitteln zum Erfassen der resultierenden Spannungen an den Zeilenleitern ($l_1$-$l_m$), die über Widerstände mit der zweiten vorgegebenen Spannung vorgespannt sind, gekennzeichnet durch Mittel, die auf das Auftreten einer Spannung gleich der zweiten vorgegebenen Spannung an einem der Zeilenleiter ($I_1$-$I_m$) bei Ansteuerung des mit diesem Zeilenleiter permanent kurzgeschlossene Spaltenleiters mit der ersten Spannung ansprechen, um ein Öffnen der Schaltung dieses Spaltenleiters zu diagnostizieren.

6. Vorrichtung nach Anspruch 5, in Verbindung mit der Tastatur nach Anspruch 2, gekennzeichnet durch Mittel, die auf das Auftreten einer Spannung gleich der vorgegebenen ersten Spannung an einem Spaltenleiter ansprechen, wenn die beiden Spaltenleitern, die mit den festen Kontakten des Schalters ($T_1$-$T_4$) verbunden sind, dessen beweglicher Kontakt mit dem besagten Zeilenleiter verbunden ist, nacheinander mit dieser ersten Spannung angesteuert werden, um eine Kurzschlußverbindung dieses Zeilenleiters mit der ersten Spannung zu diagnostizieren.

7. Vorrichtung nach einem der Ansprüche 5 und 6, gekennzeichnet durch Mittel, die auf das Auftreten der ersten Spannung an einem Zeilenleiter bei fehlender Ansteuerung des mit diesem Zeilenleiter kurzgeschlossenen Spaltenleiters mit dieser ersten Spannung ansprechen, um eine Kurzschlußverbindung des Spaltenleiters mit der ersten Spannung zu diagnostizieren.

8. Vorrichtung nach einem der Ansprüche 5 bis 7, gekennzeichnet durch Mittel, die auf das Auftreten der zweiten Spannung an einem Zeilenleiter nach der Ansteuerung des mit diesem Zeilenleiter kurzgeschlossenen Spaltenleiters mit der ersten Spannung ansprechen, um ein Öffnen der Schaltung dieses Zeilenleiters zu diagnostizieren.

9. Vorrichtung nach einem der Ansprüche 5 bis 7, bei der die Mittel zum Erfassung der Spannungen der Zeilenleiter Teil eines Rechners (2) bilden, der m Pins aufweist, welche stromgeschützt und jeweils mit einem der Zeilenleiter verbunden sind, dadurch gekennzeichnet, daß der Rechner Mittel aufweist, die auf ein Auflösen des Selbstschutzes des mit einem Zeilenleiter verbundenen Pins nach Ansteuerung des mit diesem Zeilenleiter permanent kurzgeschlossenen Spaltenleiters mit der zweiten Spannung ansprechen, um eine Kurzschlußverbindung dieses Zeilenleiters mit der zweiten Spannung zu diagnostizieren.

10. Vorrichtung nach einem der Ansprüche 5 bis 9, bei der die Mittel zum Ansteuern der Spaltenleiter mit Spannung Transistoren (14, 15, 16, 17) sind, die von einem Rechner (2) gesteuert werden, der auf das Auftreten eines Überstroms in einem der Transistoren anspricht, um diesen zu sperren, dadurch gekennzeichnet, daß der Rechner (2) Mittel aufweist, die dazu dienen, eine Kurzschlußverbindung eines Spaltenleiters mit der vorgegebenen zweiten Spannung in Abhängigkeit vom Auftreten eines Überstroms in dem diesen Leiter steuernden Transistor zu diagnostizieren.

11. Vorrichtung nach Anspruch 5, in Verbindung mit der Tastatur gemäß Anspruch 3, dadurch gekennzeichnet, daß sie ferner aufweist: Mittel zum sequentiellen Ansteuern jedes der Spaltenleiter mit der vorgegebenen zweiten Spannung über einen Transistor (16'), der mit Mitteln zum Erfassen eines Überstroms versehen ist, und Mittel, die auf das Auftreten eines derartigen Überstroms in diesem Transistor bei Ansteuerung eines Spaltenleiters mit der vorgegebenen zweiten Spannung ansprechen, um das Vorhandensein einer Kurzschlußverbindung des mit diesem Spaltenleiter permanent kurzgeschlossenen Zeilenleiters mit der ersten Spannung zu diagnostizieren.

12. Verwendung einer Vorrichtung nach einem der Ansprüche 5 bis 11, zum Prüfen und Diagnostizieren einer Tastatur zum Steuern eines Kraftfahrzeugsitzes.

13. Verwendung nach Anspruch 12, dadurch gekennzeichnet, daß die vorgegebene erste und zweite Spannung von der Massespannung bzw. der Spannung ($+V_{bat}$) der Fahrzeugbatterie gebildet werden.

## Claims

1. Control keypad consisting of a matrix arrangement of switches controlled by keys, these switches being distributed between $\underline{m}$ row conductors ($I_1$ to $I_m$) and $\underline{n}$ column conductors ($c_1$ to $c_n$), each for selectively controlling the making of an electrical contact between the row and column conductors, respectively, of a particular pair of such conductors, the status of each switch (M, $I_1$ to $I_3$, $T_1$ to $T_4$) being detected by sequential imposition of a first predetermined voltage on each of the column conductors and reading of the resulting voltages on the row conductors, which are biassed at a second predetermined voltage different from the first, this keypad being characterized in that each row conductor ($I_1$ to $I_m$) or column conductor ($c_1$ to $c_n$) is in permanent short-circuit with at least one column or row conductor, respectively.

2. Keypad according to Claim 1, comprising at least one switch ($T_1$ to $T_4$) with moving contact pivoting between two fixed contact blocks (AV,AR;H,B), characterized in that the moving contact of the switch is electrically connected to a specific row

conductor ($l_1$ to $l_m$), between two adjacent column conductors which are each electrically connected to one of the two fixed contact blocks.

3. Keypad according to claim 2, characterized in that each row conductor is connected to at least one switch with moving contact pivoting between two fixed contact blocks.

4. Keypad according to claim 1, having only switches with two fixed contact blocks and a contact which moves between an open position and a closed position on these blocks, characterized in that it comprises means (16,16') for selectively applying one or other of the first and second predetermined voltages to each column conductor ($c_1$ to $c_n$).

5. Device for reading and diagnosing malfunctions of the keypad according to any one of Claims 1 to 4, comprising means for sequentially setting the column conductors ($c_1$ to $c_n$) to the first predetermined voltage and means for reading the resulting voltages on the row conductors ($l_1$ to $l_m$), which are biassed through resistors at the second predetermined voltage, characterized in that it comprises means which can sense the reading of a voltage equal to the second predetermined voltage on any one of the row conductors ($l_1$ to $l_m$) when the column conductor in permanent short-circuit with this row conductor is set to the first voltage, to diagnose an opening of the circuit of this column conductor.

6. Device according to claim 5, in combination with the keypad according to claim 2, characterized in that it comprises means which can sense the reading of a voltage equal to the first predetermined voltage on a column conductor in the event of the successive setting to this first voltage of the two column conductors connected to the fixed contacts of the switch ($T_1$ to $T_4$) whose moving contact is connected to the said row conductor, in order to diagnose a short-circuit to the first voltage of the said row conductor.

7. Device according to either one of Claims 5 and 6, characterized in that it comprises means which can sense the reading of the first voltage on a row conductor, without the column conductor in short-circuit with the said row conductor having been set to this first voltage, in order to diagnose a short-circuit of the column conductor to the first voltage.

8. Device according to any one of Claims 5 to 7, characterized in that it comprises means which can sense the reading of the second voltage on a row conductor after the column conductor in permanent short-circuit with this row conductor has been set to the first voltage, in order to diagnose an opening of the circuit of the said row conductor.

9. Device according to any one of Claims 5 to 7, in which the means for reading the voltages of the row conductors form part of a computer (2) comprising m pins which have automatic current protection and are each connected to one of the said row conductors, characterized in that the said computer comprises means which can sense the triggering of the automatic protection of the pin connected to a row conductor, after the column conductor in permanent short-circuit with this row conductor has been set to the second voltage, in order to diagnose a short-circuit of this row conductor to the second voltage.

10. Device according to any one of Claims 5 to 9, in which the means for voltage control of the column conductors are transistors (14,15,16,17) controlled by a computer (2) which can sense the detection of an overcurrent in any one of these transistors in order to turn it off, characterized in that the computer (2) comprises means for diagnosing a short-circuit of a column conductor to the second predetermined voltage, in response to the detection of an overcurrent in the control transistor of this conductor.

11. Device according to claim 5, in combination with the keypad according to claim 3, characterized in that it furthermore comprises means for sequentially setting each of the column conductors to the second predetermined voltage, through a transistor (16') equipped with means for detecting an overcurrent, and means which can sense the detection of such an overcurrent in this transistor on setting a column conductor to the second predetermined voltage, in order to diagnose the presence of a short-circuit to the first voltage of the row conductor in permanent short-circuit with this column conductor.

12. Use of a device according to any one of Claims 5 to 11 for reading and for diagnosing a control keypad of a motor vehicle seat.

13. Use according to claim 12, characterized in that the first and second predetermined voltages consist of the earth voltage and the voltage ($+V_{bat}$) of the battery of the vehicle, respectively.

FIG.:1

(TECHNIQUE ANTERIEURE)

FIG.:2

FIG.:4

FIG.:3

PHASE 0   PHASE 2   PHASE 4   PHASE 1

PHASE 1   PHASE 3   PHASE 0

10